(19) Europäisches Patentamt
European Patent Office
Office européen des brevets

(11) **EP 3 106 867 B1**

(12) **EUROPÄISCHE PATENTSCHRIFT**

(45) Veröffentlichungstag und Bekanntmachung des Hinweises auf die Patenterteilung:
**27.12.2017 Patentblatt 2017/52**

(51) Int Cl.:
***G01N 27/62*** *(2006.01)*

(21) Anmeldenummer: **15172937.3**

(22) Anmeldetag: **19.06.2015**

(54) **VERFAHREN UND VORRICHTUNG ZUR IDENTIFIZIERUNG VON GASEN**

METHOD AND DEVICE FOR IDENTIFYING GASES

PROCEDE ET DISPOSITIF DESTINES A L'IDENTIFICATION DE GAZ

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(43) Veröffentlichungstag der Anmeldung:
**21.12.2016 Patentblatt 2016/51**

(73) Patentinhaber: **Airsense Analytics GmbH**
**19061 Schwerin (DE)**

(72) Erfinder:
• **WALTE, Andreas**
**19059 Schwerin (DE)**
• **MUENCHMEYER, Wolf**
**38468 Ehra-Lessien (DE)**
• **UNTGETHUEM, Bert**
**19059 Schwerin (DE)**

(74) Vertreter: **Gulde & Partner**
**Patent- und Rechtsanwaltskanzlei mbB**
**Wallstraße 58/59**
**10179 Berlin (DE)**

(56) Entgegenhaltungen:
WO-A2-2013/080044      DE-A1-102007 052 802
GB-A- 2 437 832

• **MAYER T ET AL: "Accuracy of ion mobility measurements dependent on the influence of humidity", ANALYTICAL CHEMISTRY, Bd. 86, Nr. 10, 20. Mai 2014 (2014-05-20), Seiten 5069-5076, XP055230263, US ISSN: 0003-2700, DOI: 10.1021/ac5007393**
• **MOLL V ET AL: "Control of dopants/modifiers in differential mobility spectrometry using a piezoelectric injector", THE ANALYST, Bd. 137, Nr. 6, 8. Februar 2012 (2012-02-08), Seite 1458, XP055230427, GB ISSN: 0003-2654, DOI: 10.1039/c2an16109e**

**Beschreibung**

Die Erfindung bezieht sich auf ein Verfahren zur Identifizierung von Gasen nach dem Oberbegriff des Anspruchs 1.

Derartige Verfahren und die dazugehörigen Vorrichtungen zur Detektion und Identifizierung von Gasen werden zur Erkennung und zum Nachweis von chemischen Stoffen oder Verbindungen, insbesondere von explosiven und/oder gesundheitsschädigenden, in sehr geringen Konzentrationen nachzuweisende Stoffen oder Stoffverbindungen eingesetzt.

Der Nachweis explosiver und/oder toxischer chemischer Verbindungen erfordert Messverfahren mit Nachweisgrenzen im ppt-ppb-Bereich. Zur Erkennung und zum Nachweis dieser chemischen Verbindungen werden deshalb häufig Spektrometer eingesetzt. Dabei ist die Verwendung von Ionenmobilitätsspektrometern (IMS), die auch als Plasma-Chromatographen bezeichnet werden, zu bevorzugen, weil sie im Gegensatz zu anderen Spektrometern, wie z. B. einem Massenspektrometer, bei Atmosphärendruck betrieben werden und keine Vakuumpumpe zur Erzeugung eines evakuierten Detektionsraumes benötigen. Deshalb sind IMS gegenüber anderen Spektrometern in ihrer Bauausführung klein und kostengünstig.

Der Anwendungsbereich der IMS ist sehr groß. Er reicht vom medizinischen Bereich, z. B. bei der Untersuchung der Ausatemluft von Patienten, über den Einsatz zur Produktionsüberwachung, z. B. bei der Qualitätskontrolle bei Lebensmitteln bis zum militärischen Bereich, z. B. beim Nachweis von Kampfstoffen. Eine allgemeine Übersicht über IMS und deren Anwendungen finden sich beispielsweise in: G.A. Eiceman und Z. Karpas "Ion Mobility Spectrometry" (2nd. Edition, CRC, Boca Raton, 2005).

Der Aufbau und die Funktionsweise des IMS sind in einer Vielzahl von Veröffentlichungen beschrieben.

So wird beispielsweise in der US 3621240 ein klassisches Flugzeit-IMS vorgestellt, bei dem die unterschiedliche Beweglichkeit von Ionen bei Atmosphärendruck ausgenutzt wird. Die über ein Einlasssystem, z. B. eine Silikonmembran oder eine Gaschromatographische Säule, in das IMS überführten Zielverbindungen werden kontinuierlich in einer Ionenquelle entweder mittels radioaktiver Strahlung, Photoionisierung oder Koronaentladungen ionisiert. Sehr häufig werden radioaktive Quellen verwendet, die direkt Luftmoleküle (Sickstoff und Sauerstoff) ionisieren. Diese ionisierten Luftmoleküle bilden die Reaktant-Ionen $H^+[H_2O]_n$ und $O_2^-[H_2O]_n$. Diese Reaktant-Ionen reagieren mittels Protonentransfer-, Elektronentransfer- oder Protonenabstraktions-Reaktionen mit den interessierenden Verbindungen und bilden Produkt-Ionen $MH^+[H_2O]_n$ und $MO_2^-[H_2O]_n$. In Abhängigkeit von Konzentration, Dipolmoment und Feuchtigkeit bilden sich z. B. bei hohen Zielverbindungskonzentrationen Dimere $M_2H^+[H_2O]_n$. oder bei hoher Restfeuchtigkeit Cluster mit einer erhöhter Anzahl von Wassermolekülen n.

Diese Produkt-Ionen werden in einer sehr kurzen Zeitspanne von ca. 200 Mikrosekunden mit Hilfe eines elektrischen Gitters in eine Driftröhre eingelassen, welche ein elektrisches Feld aufweist und die Ionen in einem Driftgas, üblicherweise gefilterte Luft bei Umgebungsdruck, beschleunigt. Gewöhnlich wird das Driftgas in einem pneumatisch geschlossenem Gaskreislauf geführt. In diesem Driftgaskreislauf sind Elemente, wie z. B. Filter, enthalten die das Driftgas reinigen und konditionieren, denn der Zustand des Driftgases hat entscheiden Einfluss auf die Detektionsfähigkeiten. Als Filter findet z. B. ein Molsieb Anwendung, mit dessen Hilfe die Feuchtigkeit des Driftgases bis auf einen Restfeuchtegehalt im unteren ppm Bereich reduziert wird. Eine kontinuierliche Filterung ist notwendig, da durch das Einlasssystem ständig Umgebungsfeuchte, wenn auch im geringen Maße, in das IMS Einlass findet.

Durch die Änderung der Polarität des elektrischen Feldes der Driftstrecke können in einem positiven Betriebsmodus positive Ionen und in einem negativen Betriebsmodus negative Ionen nachgewiesen werden. Durch das elektrische Feld werden die eingelassenen Produkt-Ionen ständig beschleunigt und durch Stöße mit den neutralen Molekülen im Driftgas ständig abgebremst. Durch das elektrische Feld wirkt auf alle Ionen mit gleicher Ladung die gleiche Zugkraft. Da aber die Produkt-Ionen verschiedene Massen und Stoßquerschnitte aufweisen, sind sie durch unterschiedliche Driftgeschwindigkeiten charakterisiert. Am Ende der Driftröhre treffen die Produkt-Ionen mit diesen unterschiedlichen Driftgeschwindigkeiten auf einen Detektor auf. Aus den unterschiedlichen Flugzeiten der Produkt-Ionen durch die Driftröhre, die typischerweise im Bereich von 5 bis 30 Millisekunden liegen, lassen sich Rückschlüsse auf die untersuchten chemischen Verbindungen ziehen. Aus der gemessenen Flugzeit oder Driftzeit und der bekannten Länge der Driftstrecke kann die Driftgeschwindigkeit bestimmt werden. Die Driftgeschwindigkeit der Produkt-Ionen $v_d$ ist bei geringer Feldstärke $E$, z. B. E = 200 V/cm, linear abhängig von der Feldstärke. Bei diesen geringen Feldstärken ist dann die Beweglichkeit oder Mobilität $K$ der Produkt-Ionen unabhängig von der Feldstärke und lässt sich wie folgt ausdrücken:

$$K = v_d / E \, .$$

Da die Messungen bei Atmosphärendruck stattfinden ist die Driftgeschwindigkeit der Ionen auch von der Temperatur $T$, dem Druck $p$ und der Restfeuchtigkeit in der Driftröhre abhängig. Zur Erkennung und zum Nachweis der chemischen Verbindungen wird die Beweglichkeit oder Mobilität der Produkt-Ionen immer auf Normalbedingungen, also auf eine Normaltemperatur $T_0$ = 273°K und einem Normaldruck $p_0$ = 1013hPa bezogen. Somit erfolgt eine Temperatur- und Druckkompensation. Die reduzierte oder normalisierte Beweglichkeit oder Mobilität der Produkt-Ionen lässt sich dann wie folgt darstellen:

$$K_0 = K \cdot (T_0 / T) \cdot (p / p_0) = K \cdot (273°K/T) \cdot (p / 1013hPa) \, .$$

Von Nachteil bei der Verwendung des klassischen Flugzeit-IMS ist aber, dass die Restfeuchtigkeit im Driftgaskreislauf sich ändert. Die Restfeuchte im Driftgas hat aber entscheidenden Einfluss auf die Detektionsfähigkeiten. Siehe auch Mayer, Thomas; Borsdorf, Helko (2014): Accuracy of Ion Mobility Measurements Dependent on the Influence of Humidity. In: Anal. Chem. 86 (10), S. 5069-5076. Die Anzahl **n** der Wassermoleküle beeinflusst direkt die Masse und den Stoßquerschnitt des Clusters, dessen Driftgeschwindigkeit und somit dessen ermittelte reduzierte Mobilität. Bei unterschiedlichen Restfeuchten im Driftgas ist somit mit einer unterschiedlichen reduzierten Mobilität zu rechnen. Insbesondere bei Produkt-Ionen mit hoher Mobilität, z. B. Chlorid-Ionen Cluster ist dieses Verhalten deutlich ausgeprägt. So ist bei dem Produkt-Ion $Cl^-[H_2O]_n$ bei mittleren Restfeuchten unter 1 ppm mit einer reduzierten Mobilität $K_0$ = 2,80 $cm^2/V/s$ zu rechnen, bei mittleren Restfeuchten bei 4ppm mit einer reduzierten Mobilität von $K_0$ = 2,55 $cm^2/V/s$. Die reduzierte Mobilität des Produkt-Ion $Cl^-[H_2O]_n$ kann somit auch als Feuchteindikator angesehen werden. Bedingt durch die unterschiedliche Neigung von Produkt-Ionen mit Wassermolekülen Cluster einzugehen ist mit einer Verschlechterung der Differenzierung von Produkt-Ionen zu rechnen. Die Wahrscheinlichkeit von Fehlidentifikationen steigt. Der Einsatz von Restfeuchtesensoren führt hier nicht zum gewünschten Ergebnis, da einerseits bedingt durch die geringe Restfeuchte im unteren ppm Bereich nur sehr teure und große Sensoren, z. B. Taupunktspiegel Sensoren zum Einsatz kommen können und andererseits eine automatische Anpassung der Restfeuchte nicht möglich ist.

DE 10 2007 052 802 A1 offenbart ein Ionenmobilitätsspektrometer und ein Verfahren zu seinem Betrieb bei dem eine Probenzufuhr in einen Reaktionsraum über einen geschlossenen inneren Gaskreislauf und mindesten einem Membraneinlass erfolgt. Eine Zuflussmenge von substanzhaltigem Kreislaufgas aus einer inneren Kammer eines Membraneinlasses in den Reaktionsraum oder die Ausbreitung des substanzhaltigen Kreislaufgases in dem Reaktionsraum wird gesteuert, indem innerhalb des Gaskreislaufs Stömungswiderstände oder Gaswege geändert werden.

Aus "analytical chemistry", Band 86, Nr. 10, 20.05.2014, Seiten 5069 bis 5076 ist bekannt, das eine Restfeuchte in einem Driftraum eines Ionenmobilitätsspektrometers durch Ermittlung einer Mobilität eines Produkt-Ions bestimmt werden kann.

Der Erfindung liegt daher die Aufgabe zu Grunde, ein Verfahren zur Identifizierung von Gasen mit einem IMS sowie eine dazugehörige Vorrichtung zu entwickeln, die einen einfachen kompakten Aufbau besitzt sowie eine Bestimmung als auch eine Einstellung der Restfeuchte erlaubt.

Diese Aufgabe wird durch die Merkmale des Anspruchs 1 gelöst. Zweckdienliche Ausgestaltungen ergeben sich aus den Unteransprüchen genannten Merkmale.

Durch das erfindungsgemäße Verfahren zur Identifizierung von Gasen, bei dem die zu identifizierenden Gase ionisiert und die Driftzeiten von Produktionen durch einen Driftraum gemessen und die gemessen Driftzeiten ausgewertet werden, wobei zur Messung der Driftzeiten die Produktionen durch ein resultierendes elektrisches Feld auf Driftgeschwindigkeiten in dem Driftraum beschleunigt werden und in den Driftraum ein Driftgas entgegen der Bewegungsrichtung der Produktionen eingeleitet wird, wobei eine Driftgasgeschwindigkeit des Driftgases im Driftraum variiert wird, und dass durch die Modifikation der Driftgasgeschwindigkeit im Driftraum eine konstante mittlere Restfeuchte im Driftraum eingestellt wird, ist vorteilhaft möglich, eine Restfeuchte in dem Driftraum auf einem konstanten Niveau zu halten. So kann insbesondere eine Restfeuchteänderung, die sich z. B. aufgrund eines Nachlassens von Filtereigenschaften des eingesetzten Filters sich ergibt, kompensiert werden. Die Messgenauigkeit des Verfahrens zur Identifizierung von Gasen wird somit erhöht.

Hierdurch wird vorteilhaft möglich, dass durch diese eingestellte konstante mittlere Restfeuchte kleinere Restfeuchteabweichungen im Driftraum durch die Variation der Driftgasgeschwindigkeit ausgeglichen werden können, so dass sich die konstante mittlere Restfeuchte einstellt. Hierdurch wird das Verfahren zur Identifizierung von Gasen mit einer hohen Messgenauigkeit durchführbar.

In bevorzugter Ausgestaltung der Erfindung ist vorgesehen, dass gleichzeitig mit der Variation der Driftgasgeschwindigkeit im Driftraum der Gesamtdriftgasfluss variiert wird, um eine Driftgasgeschwindigkeit in einem Reaktionsraum konstant zu halten. Hierdurch wird vorteilhaft erreicht, dass eine Variation der Driftgasgeschwindigkeit im Driftraum, die Einfluss auf den Gesamtgasdriftfluss hat, nicht dazu führen kann, dass die Driftgasgeschwindigkeit in den Reaktionsraum sich verändert. Das zu identifizierende Gas wird somit mit einer konstanten Geschwindigkeit in den Reaktionsraum auf die Ioneneinlassvorrichtung geführt. Insofern kann durch die Variation der Driftgasgeschwindigkeit im Driftraum die Einstellung der Restfeuchte sehr genau erfolgen.

In weiterer bevorzugter Ausgestaltung der Erfindung ist vorgesehen, dass als Driftgas Wasserdampf in Luft und/oder ein Dopandgas in Luft, insbesondere Ammoniak oder Aceton verwendet wird. Soweit hier von Wasserdampf und/oder Dopandgas in Luft gesprochen wird, wird hierunter das Gasgemisch der Erdatmosphäre verstanden. Bei der Verwendung von Wasserdampf kann die mittlere Feuchte modifiziert werden. Bei der Verwendung eines Dopandgases, beispielsweise von Ammoniak oder Aceton kann die mittlere Konzentration des Dopandgases modifiziert werden, wodurch die Detektionseigenschaften des IMS beeinflusst werden können. Auch kann eine kombinierte Modifikation von mittlerer Wasserdampf- und Dopandgaskonzentration erfolgen.

Die Erfindung wird nachfolgend anhand eines Ausführungsbeispiels in den nachfolgenden Figuren näher erläutert.

Fig. 1: einen Aufbau eines klassischen Flugzeit-Ionenmobilitätsspektrometers;

Fig. 2: einen Aufbau eines klassischen Flugzeit-Ionenmobilitätsspektrometers mit geschlossenem Driftgaskreislauf gemäß dem Stand der Technik;

Fig. 3: einen Aufbau eines klassischen Flugzeit-Ionenmobilitätsspektrometers mit geschlossenem Driftgaskreislauf entsprechend der Erfindung;

Fig. 4: eine Verteilung der Feuchte in einem Ionenmobilitätsspektrometers bei konstanter Reaktionsraum und Driftraum Driftgasgeschwindigkeit;

Fig. 5: eine Darstellung der Verschiebung der Feuchtegrenzen im koaxialen Zentrum eines Ionenmobilitätsspektrometer in Abhängigkeit vom der Driftraum Driftgasgeschwindigkeit;

Fig. 6: eineDarstellung der mittleren Restfeuchte im Driftraum in Abhängigkeit vom der Driftraum Driftgasgeschwindigkeit;

Fig. 7: eine Driftzeit von den $Cl^-[H_2O]_n$ (7,288ms) und den Reaktant-Ionen (8,212ms) bei etwa gleichen Reaktionsraum und Driftraum Driftgasgeschwindigkeit;

Fig. 8: eine Driftzeit von den $Cl^-[H_2O]_n$ (7,556ms) und den Reaktant-Ionen (8,312ms) bei etwa um 40% reduzierten Driftraum Driftgasgeschwindigkeit;

Fig. 9: eine Driftzeit von den $Cl^-[H_2O]_n$ (7,944ms) und den Reaktant-Ionen (8,46ms) bei etwa um 75% reduzierten Driftraum Driftgasgeschwindigkeit; und

Fig. 10: eine Driftzeit von den $Cl^-[H_2O]_n$ (8,288ms) und den Reaktant-Ionen (8,64ms) bei etwa um 98% reduzierten Driftraum Driftgasgeschwindigkeit.

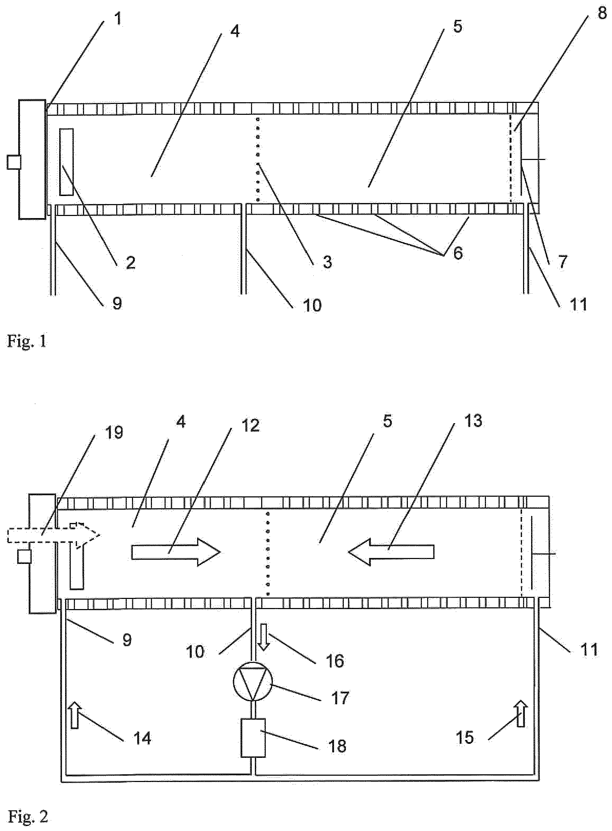

In Fig.1 werden die Hauptkomponenten eines klassischen Flugzeit-IMS dargestellt.

Die chemischen Verbindungen gelangen über ein Einlasssystem 1 in eine Ionenquelle 2 wo die Ionen erzeugt werden. Ein elektrisches Ionentor 3 verhindert, dass die Ionen aus einem Reaktionsraum 4 in einen Driftraum 5 gelangen. Die elektrische Feldstärke in der Driftröhre (Driftraum 5) beträgt ca. 200V/cm und wird über entsprechende Potentiale an Elektroden 6 aufgebaut. Die Driftröhren werden üblicherweise aus alternierenden Metall- und Isolator-Ringen aufgebaut. Das elektrische Ionentor 3 trennt den Reaktionsraum 4, wo sich die Ionenquelle 2 befindet, vom Driftraum 5. Diese Ionentore 3 können aus zwei elektrisch leitfähigen Kammstrukturen in einer Ebene, die auf unterschiedlichen Potentialen liegen, bestehen und werden auch Bradbury-Nielsen Gitter genannt. Üblicherweise beträgt die Potentialdifferenz ca. 100V. Da die Kammstrukturen örtlich etwas versetzt sind und sich nicht berühren liegt eine relativ hohe Feldstärke vor, so dass die Ionen nicht in die Driftröhre gelangen. Durch das Schalten des Ionentores 3 wird die Potentialdifferenz innerhalb von einigen Mikrosekunden abgebaut, so dass die Ionen in die Driftröhre gelangen können. Die Ionen werden in der Driftröhre vom elektrischen Feld in Richtung eines Detektor 7 gezogen, welcher in der Regel aus einer flachen leitfähigen Scheibe besteht und auch Faraday-Auffänger genannt wird. Vor dem Detektor 7 befindet sich ein Abschirmgitter 8, welches zu einer kapazitiven Entkopplung zwischen Ionen, die sich kurz vor dem Detektor 7 befinden, und dem Detektor 7 dient. Unterschiedliche Ionen weisen unterschiedliche Beweglichkeiten auf, so dass diese dann in zeitlicher Folge auftreffen. Durch eine Umpolung der Driftröhre (des Driftraumes 5) werden alternierend positive und negative Ionen nachgewiesen.

Fig. 2 zeigt ein klassisches Flugzeit-IMS mit geschlossenem Driftgaskreislauf gemäß dem Stand der Technik. Der Fluss, in dem geschlossenen Driftgaskreislauf, wird durch eine Pumpe 17 aufrechterhalten. Das ausströmende Driftgas 16 wird über einen Driftgasauslass 10 abgesaugt und durch einen Filter 18 geführt. Hiernach wird das Driftgas in zwei Pfade, einerseits in den Pfad 14 einströmendes Driftgas in den Reaktionsraum 4 und andererseits in den Pfad 15 einströmendes Driftgas in den Driftraum 5, aufgespalten und jeweils über einen Driftgaseinlass 9 in den Reaktionsraum 4 bzw. über einen Driftgaseinlass 11 in den Driftraum 5 geführt.

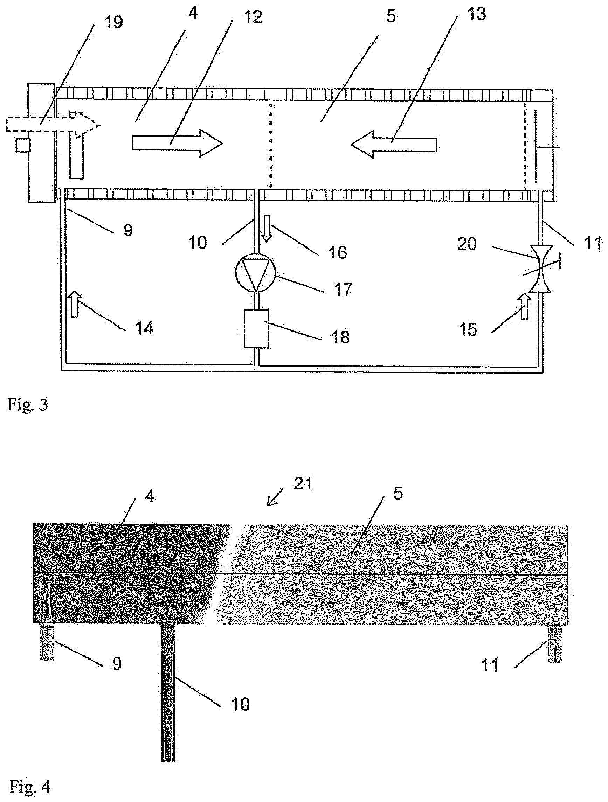

Fig. 3 zeigt ein klassisches Flugzeit-IMS mit geschlossenem Driftgaskreislauf entsprechend der Erfindung. Gleiche Teile wie in den vorergehenden Figuren sind mit gleichen Bezugszeichen versehen und nicht nochmals erläutert. Der Fluss, in dem geschlossenen Driftgaskreislauf, wird durch die Pumpe 17 aufrechterhalten. Das ausströmende Driftgas 16 wird über den Driftgasauslass 10 abgesaugt und durch den Filter 18 geführt. Hiernach wird das Driftgas in die zwei Pfade, den Pfad 14 einströmendes Driftgas in den Reaktionsraum 4 und Pfad 15 einströmendes Driftgas in den Driftraum 5, aufgespalten und über den Driftgaseinlass 9 in den Reaktionsraum 4 bzw. den Driftgaseinlass 11 in den Driftraum 5 geführt. Im Pfad 15 für das einströmende Driftgas in den Driftraum 5 befindet sich eine variable Restriktion 20 die ein einstellen einer Driftgasgeschwindigkeit 13 im Driftraum 5 ermöglicht.

Diese variable Restriktion 20 ist beispielsweise ein ansteuerbares Proportionalventil mit der ein Strömungsquerschnitt im Pfad 15 verändert werden kann. Nach einem anderen Beispiel ist die Restriktion 20 eine ansteuerbare Pumpe, mit der eine Strömungsgeschwindigkeit im Pfad 15 verändert werden kann.

Fig. 4 zeigt die Verteilung der Feuchte in einem Ionenmobilitätsspektrometers. Ein Grenzbereich der Feuchtigkeitsgrenze ist mit 21 bezeichnet. Die Eindringtiefe der Feuchtigkeit in den Driftraum 5 ist bestimmt durch die Diffusionskonstante von Wasser in Luft und eine Driftgasgeschwindigkeit 13 im Driftraum 5.

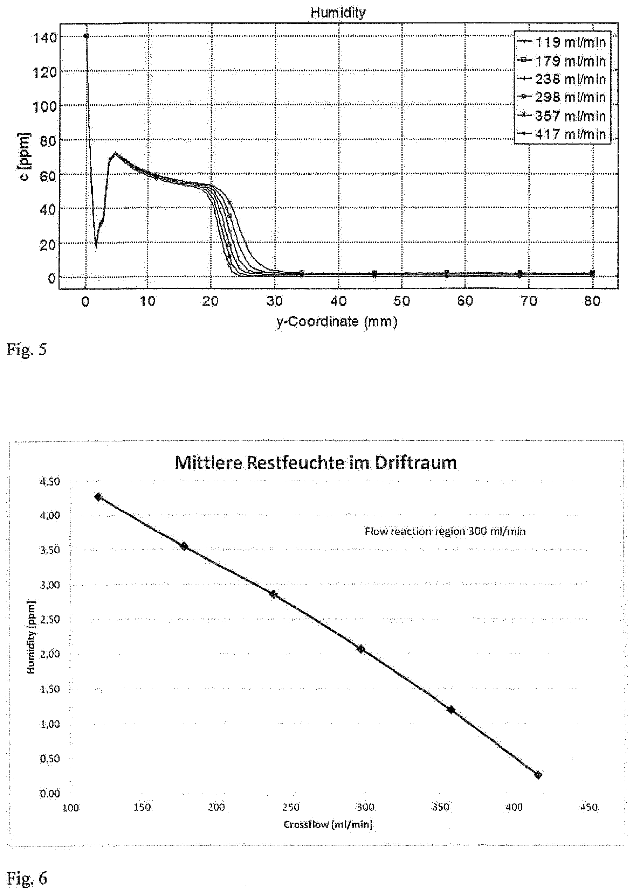

Fig. 5 zeigt die Abhängigkeit der Eindringtiefe der Feuchtigkeit in den Driftraum 5 in Abhängigkeit unterschiedlicher Driftgasgeschwindigkeiten 13 im Driftraum 5. Je niedriger die Driftgeschwindigkeit 13 ist, umso weiter wird der Grenzbereich 21 in dem Driftraum 5 verschoben.

Fig. 6 zeigt den Betrag der mittleren Restfeuchte im Driftraum 5 für Driftgasgeschwindigkeiten 13 im Bereich von 118-410 ml/min bei einer konstanten Driftgasgeschwindigkeit 12 von 300 ml/min im Reaktionsraum 4.

Vorteilhaft bei der Anwendung des neuen Verfahrens zur Restfeuchtekompensation in einem IMS ist, dass sowohl der Restfeuchtegehalt bestimmt werden kann, als auch ein nominaler Restfeuchtegehalt kontinuierlich eingestellt werden kann. Die mittlere Anzahl der Wassermoleküle in einem Produkt-Ionen Cluster während der Drift im Driftraum 5 ist abhängig von der Restfeuchte des Driftgases 13 im Driftraum 5. Diese Restfeuchte kann durch die Variation der Driftgasgeschwindigkeit 13 im Driftraum 5 eingestellt werden. Hierzu ist es von Vorteil wenn die Driftgasgeschwindigkeit z. B. durch eine variable Restriktion 20 gezielt beeinflusst wird. Die Restfeuchte im Driftraum 5 wird durch die Feuchte im Reaktionsraum 4 und die Feuchte des einströmenden Driftgases über den Driftgaseinlass 11 bestimmt. Die Feuchte im Reaktionsraum 4 wird maßgeblich durch die Umgebungsfeuchte 19 bestimmt, welche über das Einlasssytem 1 Einlass in den Reaktionsraum 4 findet. Die Feuchte des einströmenden Driftgases 11 wird maßgeblich durch den Filter 18 bestimmt. Der Erschöpfungsgrad des Filters 18 bestimmt die Fähigkeit Feuchte zu adsorbieren. Mit fortschreitender Standzeit des Filters 18 wird weniger Feuchtigkeit adsorbiert und dementsprechend steigt die Feuchte des einströmenden Driftgases 13. Bedingt durch die Diffusion der Feuchtigkeit aus dem Reaktionsraum 4 in den Driftraum 5 stellt sich im Driftraum 5 eine mittlere Restfeuchte ein. Ein weiterer Faktor, der die Restfeuchte im Driftraum 5 bestimmt ist die Driftgasgeschwindigkeit 13. Je höher die Driftgasgeschwindigkeit 13 desto geringer die mittlere Restfeuchte im Driftraum 5.

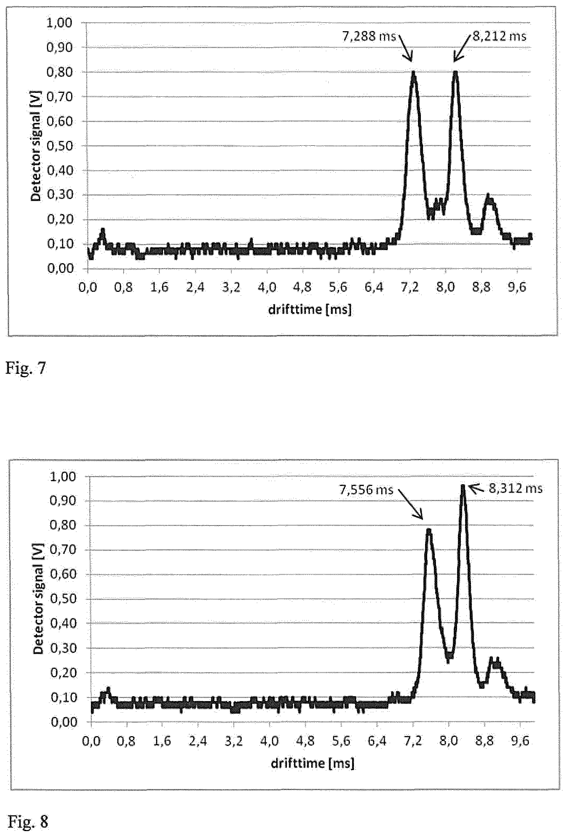

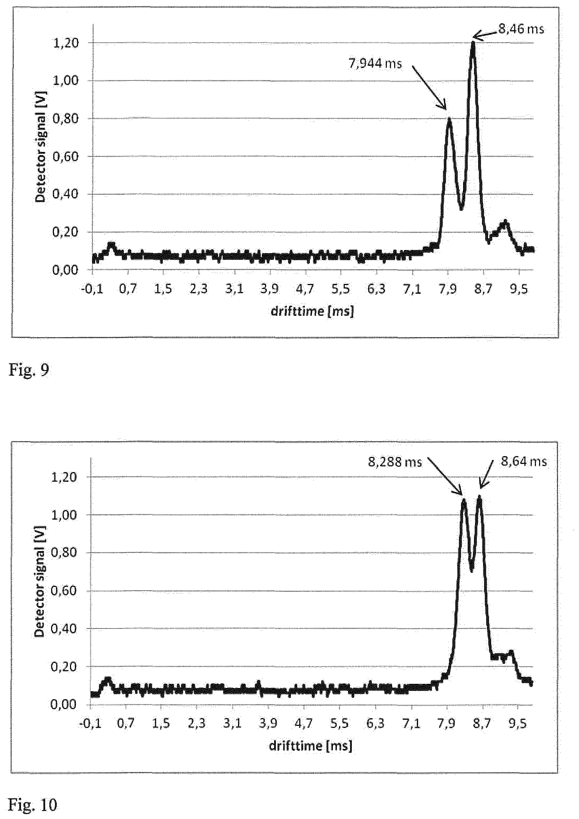

Fig. 7 - Fig. 10 zeigen die Messergebnisse eines entsprechend Fig. 3 aufgebauten IMS mit entsprechender Modifizierung der Driftgasgeschwindigkeit 13 bezüglich des Einflusses auf die Driftzeit des Chlorid-Ionen Cluster ($Cl^-[H_2O]_n$) und der Reaktant-Ionen. In Abhängigkeit von der sich einstellenden höheren Restfeuchte im Driftraum ist eine Verlängerung der Driftzeit sowohl bei dem Chlorid-Ionen Cluster ($Cl^-[H_2O]_n$) als auch bei den Reaktant-Ionen zu erkennen. Diese Tendenz ist wie zu erwarten bei dem Chlorid-Ionen Cluster ($Cl^-[H_2O]_n$) deutlicher ausgeprägt, was zu einem verschmelzen des Chlorid-Ionen Clusters ($Cl^-[H_2O]_n$) mit den Reaktant-Ionen führt. Bei noch höheren Restfeuchten wären diese beiden Ionenspezies nicht mehr zu unterscheiden.

Bezugszeichen

| 1 | Einlasssystem |
|---|---|
| 2 | Ionenquelle |
| 3 | Ionentor |
| 4 | Reaktionsraum |
| 5 | Driftraum |
| 6 | Ionenführungselektrode |
| 7 | Detektor |
| 8 | Abschirmgitter |
| 9 | Driftgaseinlass Reaktionsraum |
| 10 | Driftgasauslass |
| 11 | Driftgaseinlass Driftraum |
| 12 | Driftgas Reaktionsraum |
| 13 | Driftgas Driftraum |
| 14 | einströmendes Driftgas Reaktionsraum |
| 15 | einströmendes Driftgas Driftraum |
| 16 | ausströmendes Driftgas |
| 17 | Pumpe |

18    Feuchtefilter
19    Umgebungsfeuchte
20    variable Restriktion
21    Grenzbereich

## Patentansprüche

1. Verfahren zur Identifizierung von Gasen, bei dem die zu identifizierenden Gase ionisiert und die Driftzeiten von Produkt-Ionen durch einen Driftraum (5) gemessen und die gemessenen Driftzeiten ausgewertet werden, wobei zur Messung der Driftzeiten die Produkt-Ionen durch ein resultierendes elektrisches Feld auf Driftgeschwindigkeiten in dem Driftraum (5) beschleunigt werden, und in den Driftraum (5) ein Driftgas entgegen der Bewegungsrichtung der Produktionen eingeleitet wird, und wobei eine Driftgasgeschwindigkeit (13) des Driftgases im Driftraum (5) variiert wird und durch die Modifikation der Driftgasgeschwindigkeit (13) im Driftraum (5) eine konstante mittlere Restfeuchte im Driftraum (5) eingestellt wird.

2. Verfahren nach Anspruch 1,
   **dadurch gekennzeichnet, dass**
   gleichzeitig mit der Variation der Driftgasgeschwindigkeit (13) im Driftraum (5) der Gesamtdriftgasfluss variiert wird, um eine Driftgasgeschwindigkeit (12) in einem Reaktionsraum (4) konstant zu halten.

3. Verfahren nach einem der vorhergehenden Ansprüche,
   **dadurch gekennzeichnet, dass**
   als Driftgas Wasserdampf in Luft und/oder ein Dopandgas in Luft verwendet wird.

4. Verfahren nach Anspruch 3,
   **dadurch gekennzeichnet, dass**
   als Dopandgas Ammoniak oder Aceton verwendet wird.

## Claims

1. A method for identifying gases in which the gases to be identified are ionised and the drift times of product ions through a drift chamber (5) are measured and the measured drift times are evaluated, wherein in order to measure the drift times, the product ions are accelerated through a resulting electrical field to drift velocities in the drift chamber (5), and a drift gas is guided into the drift chamber (5) counter to the direction of movement of the product ions, and wherein
   a drift gas velocity (13) of the drift gas is varied in the drift chamber (5).

2. The method according to claim 1,
   **characterized in that**
   at the same time as the drift gas velocity (13) is varied in the drift chamber (5), the overall drift gas flow is varied in order to maintain constancy of a drift gas velocity (12) in a reaction chamber (4).

3. The method according to one of the preceding claims,
   **characterized in that**
   by modifying the drift gas velocity (13) in the drift chamber (5), a constant average residual humidity is set in the drift chamber (5).

4. The method according to one of the preceding claims,
   **characterized in that**
   water vapour and/or a dopant gas in the air is used as a drift gas.

## Revendications

1. Procédé pour l'identification de gaz, par lequel les gaz devant être identifiés sont ionisés et les temps de dérive à travers une chambre de dérive (5) d'ions-produits sont mesurés et les temps de dérive mesurés sont analysés, les ions-produits étant accélérés dans la chambre de dérive (5) jusqu'à des vitesses de dérive par un champ électrique résultant pour la mesure des temps de dérive, et, dans la chambre de dérive (5), un gaz de dérive étant introduit dans le sens de déplacement contraire des productions,
et
une vitesse de gaz de dérive (13) du gaz de dérive dans la chambre de dérive (5) étant variée et, par la modification de la vitesse de gaz de dérive (13) dans la chambre de dérive (5), une humidité résiduelle moyenne constante étant établie dans la chambre de dérive (5).

2. Procédé selon la revendication 1,
   **caractérisé en ce que**
   simultanément à la variation de la vitesse de gaz de dérive (13) dans la chambre de dérive (5), le flux de gaz de dérive total est varié afin de maintenir constante une vitesse de gaz de dérive (12) dans une chambre de réaction (4).

3. Procédé selon l'une des revendications précédentes,
   **caractérisé en ce que**
   de la vapeur d'eau dans l'air et/ou un gaz dopant dans l'air sont utilisés.

4. Procédé selon la revendication 3,
   **caractérisé en ce que**
   de l'ammoniac ou de l'acétone sont utilisés comme gaz dopant.

Fig. 1

Fig. 2

Fig. 3

Fig. 4

Fig. 5

Fig. 6

Fig. 7

Fig. 8

Fig. 9

Fig. 10

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 3621240 A

- DE 102007052802 A1

**In der Beschreibung aufgeführte Nicht-Patentliteratur**

- **G.A. EICEMAN ; Z. KARPAS.** Ion Mobility Spectrometry. CRC, 2005
- **MAYER, THOMAS ; BORSDORF, HELKO.** Accuracy of Ion Mobility Measurements Dependent on the Influence of Humidity. *Anal. Chem.,* 2014, vol. 86 (10), 5069-5076

- *analytical chemistry,* 20. Mai 2014, vol. 86 (10), 5069-5076